# EUROPEAN PATENT APPLICATION

(11) **EP 4 294 050 A1**
(43) Date of publication of application: **20.12.2023**
(21) Application number: 22179664.2
(22) Date of filing: 17.06.2022
(51) Int. Cl.: H04R 17/10, H04R 23/02, H04R 1/24, H04R 23/00

(54) **A MEMS PACKAGE AND AN AUDIO DEVICE COMPRISING SUCH A MEMS PACKAGE**

(71) Applicant: Infineon Technologies AG, 85579 Neubiberg (DE)
(72) Inventor: BRETTHAUER, Christian, 81675 München (DE); MAYRHOFER, Dominik, 8010 Graz (AT); HAUBOLD, Marco, 01309 Dresden (DE); EVERSMANN, Bjoern Oliver, 94501 Aidenbach (DE)
(74) Representative: König, Andreas Rudolf

(57) **Abstract**

A MEMS package comprises a first speaker arrangement being configured for emitting sound in a first audio frequency range and a second speaker arrangement being configured for emitting sound in a different second audio frequency range.

## Description

The present disclosure relates to a MEMS device having a first and a second speaker arrangement. The present disclosure further relates to an audio device comprising a MEMS device. The present disclosure in particular relates to a combination of woofer and tweeter MEMS for improved efficiency and full audio bandwidth frequency support.

Electrodynamic speakers can be used in tweeter-woofer-systems, TWS. They can be fairly broadband and may deliver high sound pressure levels but require a certain space which is a challenge for use/integration in TWS applications..

A MEMS device may comprise semiconductor materials, for example, on a basis of silicon, wherein electrical current may flow based on conductive materials such as metal materials and/or doping of a semiconductor material. MEMS devices may implement loudspeakers.

There is, thus, a need to improve MEMS speakers.

An object addressed by the present disclosure is, thus, to improve MEMS speakers.

According to an embodiment, a MEMS device comprises a first speaker arrangement being configured for emitting sound in a first audio frequency range and comprises a second speaker arrangement being configured for emitting sound in a different second audio frequency range. Preferred embodiments of the present disclosure are described herein whilst making reference to the accompanying drawings in which:
- Fig. 1a: shows a schematic block diagram of a MEMS device according to an embodiment;
- Fig. 1b: shows a schematic block diagram of a MEMS device according to an embodiment having a control circuitry;
- Fig. 2: shows a schematic block diagram of a MEMS device according to an embodiment wherein the control circuitry comprises an application specific integrated circuit;
- Fig. 3: shows a schematic side view of a MEMS speaker arrangement according to an embodiment;
- Fig. 4: shows a schematic side view of a part of a MEMS device according to an embodiment, wherein the details provided may be applied, without limitation, to other MEMS devices described herein.
- Fig. 5a: shows a schematic side view of a MEMS device according to an embodiment, comprising an interface to allow a connection to exchange a signal with an external control circuitry;
- Fig. 5b: shows a schematic side view of the MEMS device of Fig. 5a where a shutter structure is in a second position;
- Fig. 6a: shows a schematic top view of a part of a speaker arrangement according to an embodiment, to illustrate details of a shutter structure of a speaker arrangement;
- Fig. 6b: shows as schematic top view of a layer of a perforated structure of a speaker arrangement according to an embodiment;
- Fig. 7: shows a schematic perspective view of a part of a speaker arrangement according to an embodiment, having a plurality of valve structures;
- Fig. 8: shows a schematic a reconstruction of a sinusodial sound signal through different "digital" sound pulses generated with a unit cell array according to an embodiment;
- Fig. 9: shows a schematic top view of a part of a speaker arrangement according to an embodiment, having a plurality of valve structures; and
- Fig. 10a: shows a schematic side view of a MEMS device according to an embodiment having a plurality of membranes for each speaker arrangement;
- Fig. 10b: shows a schematic top view of the MEMS device of Fig. 11a;
- Fig. 11: shows a schematic side view of an implementation of a speaker arrangement according to an embodiment that may be used as a tweeter;
- Fig. 12a: shows a schematic top view of a MEMS die having two speaker arrangements according to an embodiment;
- Fig. 12b: shows a schematic top view on a MEMS configuration where the speaker arrangements are arranged on different dies, according to an embodiment; and
- Fig. 13: shows a schematic block diagram of an audio device according to an embodiment.

Equal or equivalent elements or elements with equal or equivalent functionality are denoted in the following description by equal or equivalent reference numerals even if occurring in different figures.

In the following description, a plurality of details is set forth to provide a more thorough explanation of embodiments of the present disclosure. However, it will be apparent to those skilled in the art that embodiments of the present disclosure may be practiced without these specific details. In other instances, well known structures and devices are shown in block diagrams form rather than in detail in order to avoid obscuring embodiments of the present disclosure. In addition, features of the different embodiments described hereinafter may be combined with each other, unless specifically noted otherwise.

Embodiments described herein relate to a MEMS device comprising at least a first speaker arrangement and a second speaker arrangement. Such a MEMS device may be a packaged MEMS device and may comprise or provide for a housing, e.g., a packaging to form a package. In connection with embodiments described herein, a package may comprise a housing or cover or lid for one or more semiconductor devices or dies or integrated circuits, e.g., to house dies, possibly for their assembly on a printed circuit board which may itself be placed in a housing. However, a package is usually not intended to be opened again. A material for such a housing may comprise, for example, a metal material, a plastic material, a glass material, a ceramic material, or a combination thereof.

The package of a MEMS device or a packaged MEMS device may be understood as a housing (or cover, or lid) that may comprise at least two chips of the at least two speaker arrangements in the same package. Further, the at least two chips of the at least two speaker arrangements may be arranged on a common substrate of the package. Thus, the packaged MEMS device could provide for a common (i.e., shared) back volume for the at least two chips of the at least two speaker arrangements, which could result in a more compact arrangement than known speaker arrangements.

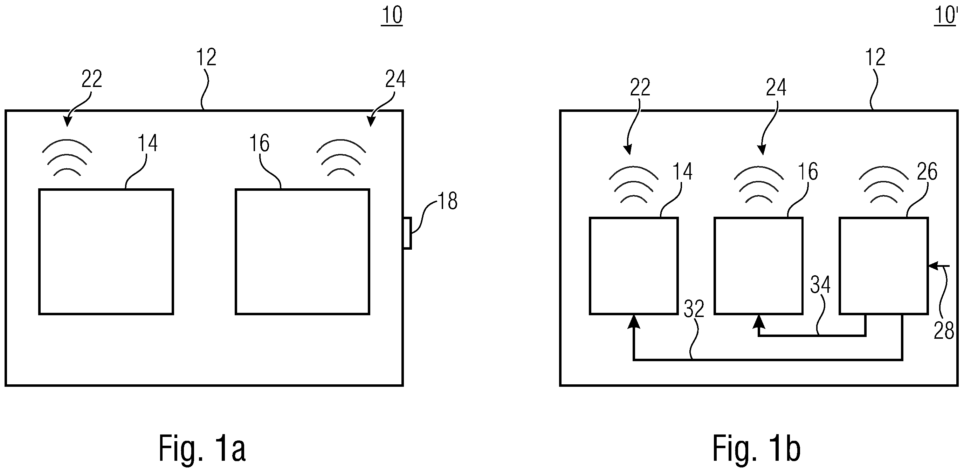

Fig. 1a shows a schematic block diagram of a MEMS device 10 according to an embodiment. The MEMS device comprises, within a same housing 12, e.g., a mode, the mentioned plastic material, glass material, ceramic material, or a combination thereof, a speaker arrangement 14 being configured for emitting sound in a first audio frequency range. The MEMS device 10 further comprises a speaker arrangement 16 configured for emitting sound in a different second audio frequency range. Although the embodiments of the present disclosure are not limited to such a configuration, speaker arrangement 14 may be configured as a woofer, i.e., to emit sound in a low frequency range. Speaker arrangement 16 may be configured as a tweeter, and may be configured for emitting sound in a frequency range that is higher when compared to the audio frequency range of speaker arrangement 14

Whilst a woofer may be understood as a speaker that emits sound, preferably in a frequency range of at most 500 Hz, at most 300 Hz or at most 200 Hz, a tweeter may be understood as a speaker that emits sound in a frequency range of at least 450 Hz and higher, of at least 1 kHz or of at least 3 kHz and higher. Both speaker arrangements 14 and 16 may comprise a respective audio frequency range that possibly may, but is not required to, overlap.

The respective speaker arrangement 14 and/or 16 may comprise a membrane or other structures to move a fluid, e.g., a cantilever. According to an embodiment, the woofer may be based on a thermo-acoustic principle and the tweeter may be based on the mechanically actuated membrane or cantilever structure, wherein both may be actuated at the audio frequency.

The MEMS device 10 may comprise an electrical connector 18 configured for a connection with an external control circuitry. From the external control circuitry, the MEMS speaker device 10 may comprise signals that form a basis for audio signals 22, 24 respectively being emitting by the speaker set ups 14, 16, respectively.

Fig. 1b shows a schematic block diagram of a MEMS device 10' according to an embodiment. The MEMS device 10' comprises speaker arrangements 14 and 16 and may comprise a control circuitry 26 configured for receiving an input signal 28 comprising audio information, e.g., an audio signal or a processed signal containing audio information. The control circuitry 26 may be configured for deriving, from the input signal 28, a control signal 32 being adapted for the speaker arrangement 14. The control circuitry 26 may provide the control signal 32 to the speaker arrangement 16 to generate the acoustic signal 22.

The control circuitry 26 may be configured for deriving a control signal 34 from the input signal 28, the control signal 34 being adapted for the speaker arrangement 16. The control circuitry 26 may provide the control signal 32 to the speaker arrangement 16 to generate the acoustic waves 24. Although being described as generating and providing control signals for each of the speaker arrangements contained in the device 10', the control circuitry 26 may provide for only a subset thereof, and may receive remaining control signals via a connector as described in connection with Fig. 1a.

When referring again to Fig. 1a, the electrical connector 18 may be configured for receiving control signals 32 and/or 34 from a control circuitry being arranged outside the MEMS device 10.

Device 10 respectively may provide for a common housing for electrically connecting the speaker arrangement 14 and the speaker arrangement 16 to an environment of the device, e.g., containing a fluid to receive sound waves 22 and/or 24. The control circuitry 26 may comprise, for example, a processing unit, a microcontroller, an application-specific integrated circuit, ASIC, a field programmable gate array, FPGA, or other suitable circuitry, configured for controlling at least one of the speaker arrangements 14 and 16.

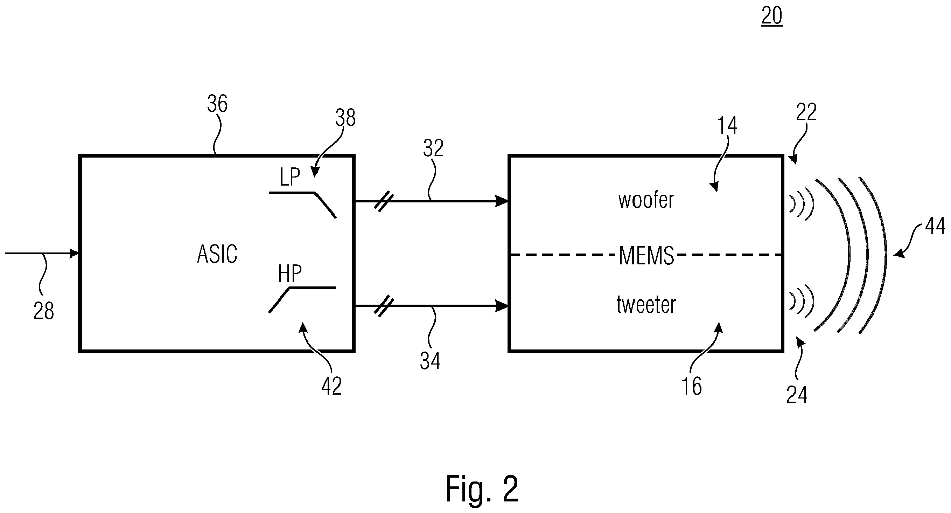

Fig. 2 shows a schematic block diagram of a MEMS device 20according to an embodiment. The MEMS device 20 may form at least a part of speaker system. An application specific integrated circuit 36 may form a part of the MEMS speaker system 20 and may implement the control circuitry 26. The ASIC 36 may receive the input signal 28, for example, as an electrical audio signal.

The ASIC 36, the control circuitry 26 respectively, may comprise a low pass filter 38 for deriving the control signal 32 having one or more channels. Control signal 32 may be considered as a woofer signal as containing information to drive a woofer. The ASIC 36, the control circuitry 26, respectively, may comprise a high pass filter 42 for deriving the control signal 34, which may be referred to as a tweeter signal having one or more channels.

The speaker arrangement 14 may be implemented as a MEMS woofer whilst speaker arrangement 16 may be implemented as a MEMS tweeter to generate acoustic waves 22 and 24 that may superimpose each other to an acoustic output signal 44, e.g., a full bandwidth acoustic audio signal.

The speaker arrangement 14 and/or the speaker arrangement 16 and/or optional additional speaker arrangements may be implemented as MEMS speakers. According to an embodiment, such MEMS speaker may comprise a membrane structure that deflects inplace or out-of-plane of a MEMS layer. According to an embodiment, the membrane structure deflects out-of-plane to generate pressure in a fluid. According to some embodiments, a membrane structure of a MEMS speaker, e.g., to generate low audio frequencies, e.g., as a woofer, may be driven with ultrasonic frequencies that are demodulated to the audible audio range for a listener. Some implementations of MEMS speaker arrangements in connection with embodiments are described in the following.

An combination of two speaker arrangements comprising same or different audio frequency ranges is described by way of non-limiting example and does not preclude MEMS devices that comprise at least a third speaker arrangement being configured for emitting sound in a third overlapping or disjoint audio frequency range, e.g., a midrange speaker and/or further speaker arrangements. A common back volume as described above, may, in case it is used, also be used for a third and possible further speaker arrangements. For example, as an alternative to speaker arrangement 14 or 16 or in addition hereto, a midrange speaker arrangement may be a part of a MEMs device described herein, e.g., MEMS device 20. For example, the control unit, e.g., ASIC 36, may comprise a bandpass filter adapted for frequency ranges operated by the midrange speaker arrangement.

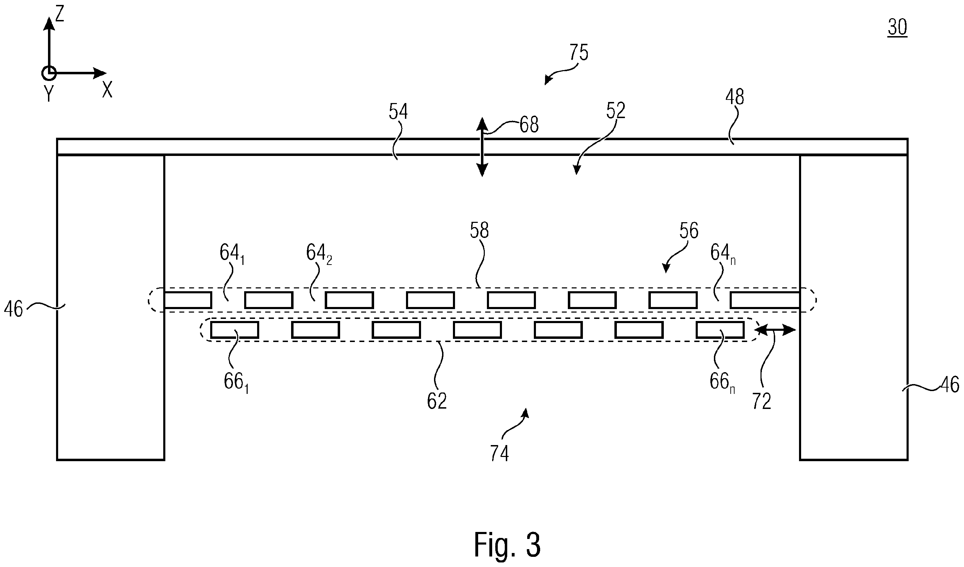

Fig. 3 shows a schematic side view of a MEMS device 30 according to an embodiment, which may be used, for example, as a speaker arrangement, e.g., a woofer. The MEMS device comprises a substrate 46, e.g., comprising a semiconductor material such as silicon or silicon based materials. Alternatively, or in addition, other types of semiconductor materials may form at least a part of substrate 46, e.g., gallium arsenide or the like.

The MEMS device 30 comprises a membrane structure 48 being mechanically connected to the substrate 46. The membrane structure 48 may be directly or indirectly hinged or connected to the substrate 46. The membrane structure 48 may be provided parallel to a substrate plane, e.g., it may be arranged in an unactuated state essentially parallel to a substrate plane x/y, i.e., in-plane. The membrane structure 48 may be deflectable out-of-plane, e.g., based on an actuation signal and/or based on a pressure of a fluid 52 being present in a cavity 54 of the MEMS device 30, of the substrate 46, respectively. The membrane structure 48 may be implemented as a planar structure having, for example, a rectangular, round or essentially square shape or a structure inbetween e.g. alveolate. The membrane structure 48 may also be formed as a cantilever beam.

By way of non-limiting example only, a MEMS device may be formed from at least one wafer or other basis structure. Such a wafer may be considered as a plate-like structure that has a comparatively low thickness when compared to longitudinal extensions. Without limiting such considerations to a specific coordinate system or realization of a structure, the longitudinal directions may be considered as defining an in-plane direction of a MEMS device. Such directions are shown in Fig. 3 as x/y-directions. A thickness direction z may be considered as a thickness direction perpendicular to the in-plane directions x/y. the membrane structure 48 may deflect out-of-plane and, thus, along a positive and/or negative z-direction.

The membrane structure 48 is configured for deflecting along the z-direction with a frequency in ultra-sonic frequency range to cause a motion of the fluid 52. The motion may comprise a flow of the fluid 52 through a valve structure 56 and/or may relate to a pressure, a change thereof or a pressure wave generated in the cavity 54. For example, the membrane structure 48 may be configured for and controlled to deflect out-of-plane with an ultrasonic frequency. That is, the deflection of the membrane structure 48 may be controlled in a frequency range inaudible for a human. However, by use of a MEMS membrane structure that possibly has a comparatively small size and thus moves a small amount of fluid, a high rate of moving such small amounts may result in considerable fluid set under pressure, e.g., in a front volume. To avoid moving the fluid 52 back and forth with the membrane structure, the controllable valve structure may be used to allow, based on a control signal for the valve structure 56, a fluid pulse or fluid motion away from the membrane structure 48 through the valve structure 56 towards a front volume 74. In addition, the MEMS device 30 may provide for a back volume 75 on a different side of the membrane structure 48. The whole MEMS device 30 may thus offer a front and a back port for fluid and/or sound.

In some possible ways of operation, based on closing the valve structure 56 during a time the membrane structure 48 moves away from the valve structure, e.g., along +z, and again opening the valve structure 56 when the membrane structure 48 moves towards the valve structure 56 again, e.g., along -z, fluid pulses or fluid 52 may be accumulated in the front volume 74. The membrane structure may move or vibrate with an ultrasonic frequency, e.g. a frequency of at least 20 kHz, at least 30 kHz or even more up to several 100 kHz, i.e., with an ultrasonic frequency rage. For example, the membrane may vibrate with a frequency of at least 50 kHz, at least 70 kHz or at least 90 kHz, e.g., approximately or equal to 96 kHz, wherein some structures may also allow for a frequency of at least 200 kHz, 300 kHz or up to 500 kHz or more to cover a range between at least 50 kHz and at most 500 kHz. Such an ultrasonic frequency range may be demodulated to an audible frequency range, i.e., an audio frequency range, e.g., below 20 kHz.

The valve structure 56 and the membrane structure 48 may together sandwich the cavity 54, wherein based on a control of valve structure 56 different fluidic resistances for the fluid may be provided. According to one example, the valve 56 may be switched between an open state in which the valve structure 56 basically provides for a low, negligible or no fluidic resistance and a second state, in which the valve structure 56 may be considered in a closed state in which the valve structure provides for a comparatively higher fluidic resistance for the fluid 52. For example, in the closed state, there may be no or only negligible flow from the fluid 52 through the valve structure 56.

The valve structure 56 may comprise a planar perforated structure 58 and a shutter structure 62 moveable with respect to the perforated structure 58. In one example, the perforated structure 58 may be an immoveable structure, e.g., a statue or the like, for example, immovably connected to the substrate 46. However, according to other examples, both structures, the perforated structure 58 and the shutter structure 62 may be moveably arranged and may move with regard to each other.

The perforated structure 58 may comprise a plurality of openings 64₁ to 64ₙ that allow the fluid 52 to pass through. According to an embodiment, the shutter structure 62 may comprise structural sections 66₁ to 66ₙ that are adapted for an opposing position with regard to the openings 64₁ to 64ₙ in the second position to provide for the second fluidic resistance.

By use of the valve structure 56, the ultrasonic waves in the cavity 54 may be transferred to other frequency ranges, e.g., an audible or audio frequency range.

Whilst using a membrane being deflectable along a direction of movement 68 being possibly parallel to the z-direction, which may allow for a large amount of fluid to be moved, a direction of movement 36 of the valve structure 56, e.g., the shutter structure 62, may allow for a low thickness of the MEMS device 30, may comprise a control unit and/or an interface for a connection with an external control unit. Such a control unit may comprise a control circuitry configured for controlling a deflection of the membrane structure 48 to deflect with a first ultrasonic frequency and for controlling the valve structure 56, e.g., an actuator structure connected to the shutter structure 62 to change between the first position and the second position with a same or a different second ultrasonic frequency to generate a sound pressure level in a front volume 74 of the MEMS device 30 in an audio frequency range, the sound pressure level in the audio frequency range being generated from the ultrasonic frequency of the membrane structure 48, i.e., by use of the valve structure 56, the membrane sound may be modulated or demodulated so as to obtain an audio signal. For example, such a demodulation/modulation may comprise an advanced digital sound reconstruction, ADSR, or other ultrasonic demodulation, UD, concepts.

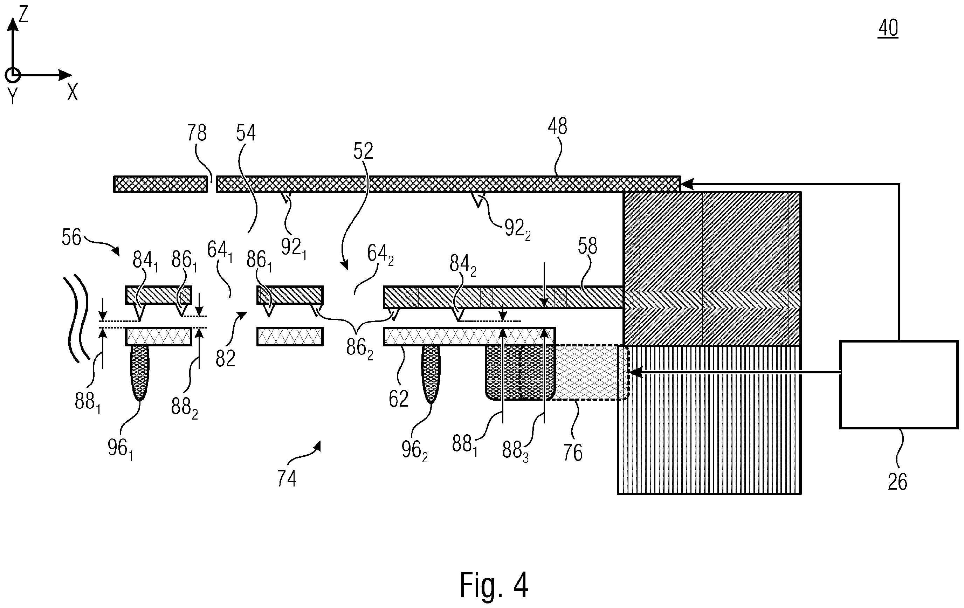

Fig. 4 shows a schematic side view of a part of a MEMS device 40 according to an embodiment, wherein the details provided may be applied, without limitation, to other MEMS devices described herein. The MEMS device 40 may form a part of a MEMS package described herein, e.g., a woofer.

MEMS device 40 comprises the control circuitry 26, e.g., comprising a processing unit, a microcontroller, an application-specific integrated circuit, ASIC, a field programmable gate array, FPGA, or other suitable circuitry, configured for controlling a deflection of the membrane structure 48. The control circuitry 26 may further be configured for controlling an actuator structure 76 connected to the shutter structure 62 to change between the first position shown in Fig. 4 and the second position indicated in Fig. 3. The change between the first position and the second position may be obtained with a same or a different ultrasonic frequency and both controls commonly may allow to generate a sound pressure level in the front volume 74, which is in the audio frequency range, i.e., in a frequency range of at least 10 Hz and at most 20 kHz. A MEMS device in accordance with embodiments described herein may have good properties especially in a low frequency audio range, e.g., in a range of at most 1 kHz, at most 800 Hz or at most 500 Hz. The actuator structure may comprise, for example, a piezoelectric actuator, an electrodynamic actuator or other types of actuating structures. For example, the actuator structure 76 may comprise an electrodynamic comb-structure, a magnetic drive, a piezoelectric drive and/or a thermal drive. The actuator structure 76 may comprise more than a single actuator, e.g., actuator structures so as to generate active forces along positive and negative directions of movement. This may allow for a highly controllable generation of sound when compared to relying on restoring forces of springs only.

By driving the membrane structure 48 and the valve structure 56 with a same or a different ultrasonic frequency, a modulation of the sound generated by the membrane structure 48 may be obtained.

A MEMS device in accordance with an embodiment may comprise a membrane structure 48 that comprises a plurality of ventilation holes 78 configured for a passage of the fluid 52 into the cavity 54 whilst preventing an acoustic short circuit. The ventilation holes 78 may have a synergetic effect and may, for example, first serve as holes that are now to etch a sacrificial layer to generate at least a part of the cavity 54. The ventilation holes 78 may comprise a comparatively low size along the x- and/or y-direction to prevent for an acoustic short circuit. That is, the ventilation holes 78 may have a high fluidic resistance with increases with ~1/d⁴ wherein d refers to a .hole diameter.

That is, the ventilation holes 78 may allow to remove the sacrificial layer without generating an acoustic short circuit. Such an acoustic short circuit may be understood as an effect that the membrane structure 48 deflects along a direction, but only provides for insufficient pressure or movement of fluid 52 as the fluidic resistance of the ventilation holes 78 is too low, such that the fluid 52 travels through such holes instead of being moved by the membrane structure. A size of the ventilation holes 78 may be tuned to achieve a fluidic resistance for the fluid 52 that is high enough to allow efficient flow generation through the valve structure 56 and to be low enough to allow for ventilation of the cavity 54 through the membrane structure 48 when the valve structure 56 is in a closed state, i.e., the shutter structure 62 is in the second position. A diameter of such a ventilation hole may be, for example, in a range of at least 0.5 µm and at most 5 µm, at least 0.7 µm and at most 4 µm or of at least 1 µm and at most 3 µm.

Alternatively or in addition to the ventilation holes 78, the MEMS structure 40 and/or the MEMS structure 30 may comprise a bump structure 82 which may have a set of bumps, a continuous or discontinuous ring-like structure of at least one bump or the like that is arranged between the perforated structure 58 and the shutter structure 62. During manufacturing of the MEMS device 40, the bump structure 82 may, for example, be formed as a part of the perforated structure 58 and/or as a part of the shutter structure 62.

In a closed state of the valve structure 56, the bump structure 82 may prevent a fluid through the valve structure 56 based on a mechanical contact between the perforated structure 58 and the shutter structure 62 via the bump structure 82. That is, although showing a remaining distance between the bump structure 82 and the shutter structure 62, the MEMS device 40 of Fig. 4 may provide for a mechanical contact of the shutter structure 62 with the bump structure 82. The bump structure 82 may synergistically allow for providing a protection against stiction of the shutter structure 62 to the perforated structure 58 and to provide for a sort of a seal, e.g., a ring, around the perforation or opening 64 to pinch-off the flow of fluid 52 in case the shutter structure 62 is in the second position.

According to an embodiment, the bump structure 82 comprises bump elements with different properties and/or for different purposes. For example, the bump elements 84₁ and 84₂ may comprise a comparatively long extension along the z-direction, i.e., they may be comparatively long. The bump elements 84₁ and 84₂ may be configured for providing a point-like contacting surface with the shutter structure 62 to provide for anti-stiction function. By having the bump elements 84₁, 84₂ with a point-like surface or at least a small contact area, good anti-stiction properties may be obtained. The bump elements 84₁ and/or 84₂ as an alternative or in addition allow to have a low amount of disturbing noise in the demodulated audio signal as a surface area that generates friction and thereby possibly noise when changing the position of the shutter structure 62 is small.

According to an embodiment, a MEMS device according to the present disclosure may provide for anti-stiction bumps between the perforated structure and the shutter structure and may comprises a sealing structure between the perforated structure and the shutter structure. A remaining gap in an area of the sealing structure may be larger when compared to a gap in an area of the anti-stiction bumps.

The bump structure 82 may alternatively or in addition comprise a continuous or segmented bump element 86 that may form at least a part of a ring through a respective opening 64₁, 64₂ respectively. When compared to the bump elements 84₁, 84₂, a length along the z-direction of bump elements 86₁, 86₂ may be smaller. A reduced length or height of bumps 86₁, 86₂ when compared to bump elements may result, at least during regular operation, in that the bump elements 86₁, 86₂ do not provide for a mechanical contact but reduce or at least partly obstruct a slit along the z-direction, the slit being between the perforated structure 58 and the shutter structure 62. That is, elements 86₁ and 86₂ are not necessarily bumps but can also for a different type of protrusion or elevation.

To have different heights of bump elements used for different purposes may allow to maintain good anti-stiction properties by use of bump elements 84₁, 84₂ even in case of having a comparatively large surface provided by sealing bumps or sealing elevations 86 as they do not necessarily contribute to the anti-stiction functionality. A gap 88₁ remaining between bump elements 84₁ and shutter structure 62 may be comparatively low, down to zero in a case where the bumps abut the opposing structure. A gap 88₂ between the bump element 86₁ or 86₂ on the one hand and shutter structure 62 on the other hand may, at a same time, be non-zero which may be interpreted as a remaining pinching slit even if the valve structure 56 is in a closed position. Such a gap may have a size, for example, of at least 100 nm and at most 1000 nm, of at least 200 nm and at most 700 nm or of at least 300 nm and at most 500 nm. A gap 88₃ between the shutter structure 62 and the perforated structure 58 may, at a same time, be in a range of at least 600 nm and at most 1500 nm. That is, bump elements 86₁ and 86₂ may provide to tighten or seal the cavity 54 even if a small gap 88₂ remains.

Bump structure 82 does not prevent bump elements 92₁ and/or 92₂ to be arranged between the membrane structure 48 and the valve structure 56. It has to be noted that the perforated structure 58 or the shutter structure 62 may be arranged closer to the membrane structure 48 when compared to the other structure.

Alternatively or in addition to the bum structure 82 and/or the ventilation holes 78, the shutter structure 62 may comprise a mechanical stiffening 96₁, 96₂ configured for suppressing an out-of-plane deflection of the shutter structure 62. For example, the mechanical stiffening 96₁, 96₂ may comprise a locally increased thickness of the shutter structure 62, e.g., a beam-like structure or a bar-like structure. Alternatively or in addition, an additional layer or structure may be arranged to locally stiffen the shutter structure to increase weight of the moved structure only as much as desired. Alternatively or in addition to the stiffening of the perforated structure, wherein the shutter structure may comprise a mechanical stiffening, the mechanical stiffening configured for suppressing an out-of-plane deflection of the shutter structure.

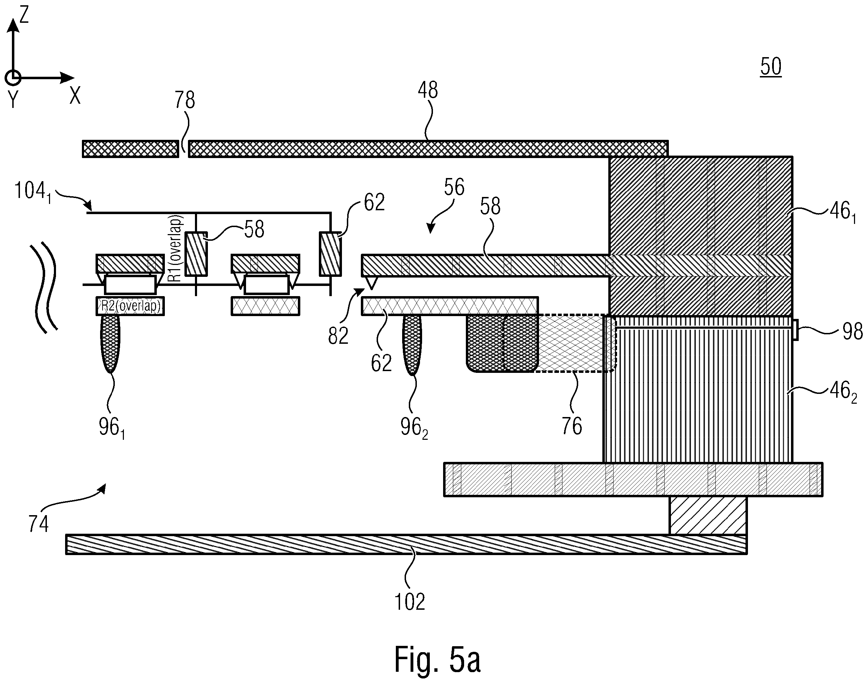

Fig. 5a shows a schematic side view of a MEMS device 50 according to an embodiment. The MEMS device 50 comprises, for example, an interface 98 to allow a connection to exchange a signal with an external control circuitry, whilst the control circuitry 26 of a MEMS device 40 may be an internal circuitry of the MEMs device. The MEMS device 50 may form a part of a MEMS package described herein, e.g., a woofer.

Alternatively or in addition, the MEMS device 50 may comprise a protective structure 102 which may also be arranged at MEMS device 30 and/or 40. The protective structure 102 may be transparent for a sound pressure level, e.g., in the audio range, of the fluid whilst being configured for mechanically protecting the valve structure 56. The protective structure 102 may sandwich the valve structure 56 together with the membrane structure, i.e., the valve structure 56 may be arranged between the membrane structure 48 and the protective structure 102. The protective structure 102 may comprise, for example, a plastic material, a semiconductor material and/or a glass material. For example, a plastic material, i.e., a membrane comprising the plastic material, may be well-suited to block ultrasonic sound whilst being transparent for audible frequencies. A glass structure forming at least a part of the protective structure 102 may comprise a mesh-like structure, may provide for a high mechanical robustness, and may comprise small openings that may at as ventilation holes.

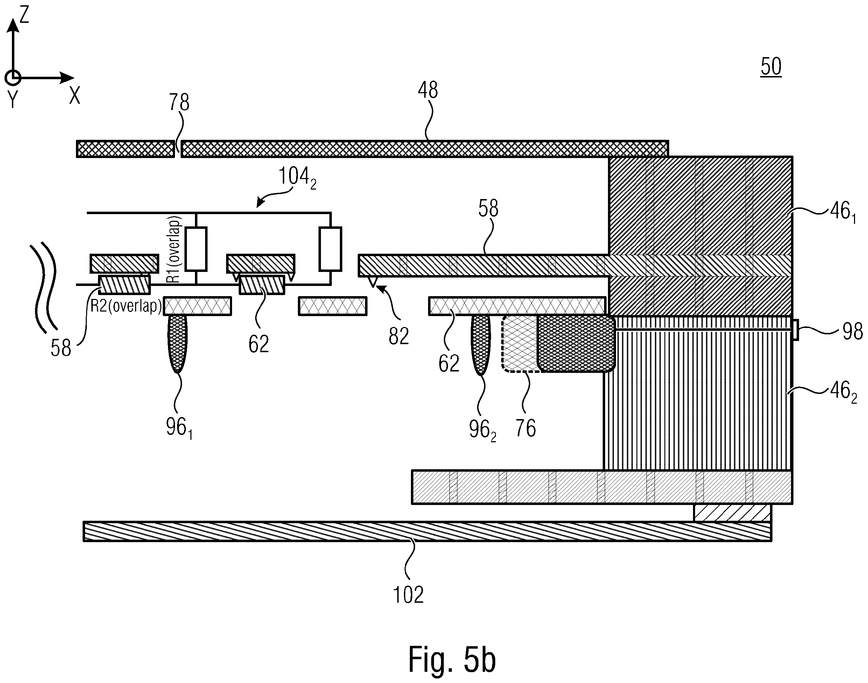

Fig. 5b shows a schematic side view of the MEMS device 50 of Fig. 5a where the shutter structure 62 is in the second position. As shown in a schematic equivalent circuit diagram 104 in Figs. 5a and 5b, the fluidic resistance of Fig. 5a represented therein may be understood as parallel connection of resistors whilst the second positon shown in Fig. 5b may result in a serial-connection. In an electronic analogy, the parallel connection may result in a lower effective resistance when compared to the serial-connection.

The external or internal control circuitry may be configured for controlling the actuator structure 76 to move the shutter structure 62 into the first position or into the second position at an instance of time based on a deflection state of the membrane structure 48 at that instance of time. That is, the control circuitry may temporally align a control of the membrane structure 48 and of the shutter structure 62. For example, the control circuitry may control the actuator structure 76 so as to provide for the first position of the valve structure at a time when the membrane provides for pressure in the cavity or may provide for a closed state of the valve structure 56 at this time. For example, the control circuitry 26 may be configured for controlling the actuator structure 76 and the membrane structure 48 for aggregating a fluidic pressure of the fluid motion generated by the membrane structure 48 to have an aggregated pressure in the front volume by use of the valve structure. In other words, the membrane structure 48 may aggregate pressure, e.g., by pumping a contribution in the front volume whilst having the valve structure 56 in an open state and the valve structure 56 may be controlled into a closed state when the membrane 48 moves back again. According to other types of ultrasonic demodulation, e.g., ADSR, the membrane structure on the one hand and the shutter position on the other hand may also be unsynchronized.

As shown, for example, in Figs. 5a and 5b, the MEMS device may comprise a bump structure between the perforated structure 58 and the shutter structure 62, the bump structure wherein, in a closed state of the valve structure, the bump structure 82 may be configured for obstructing a fluid flow through the valve structure.

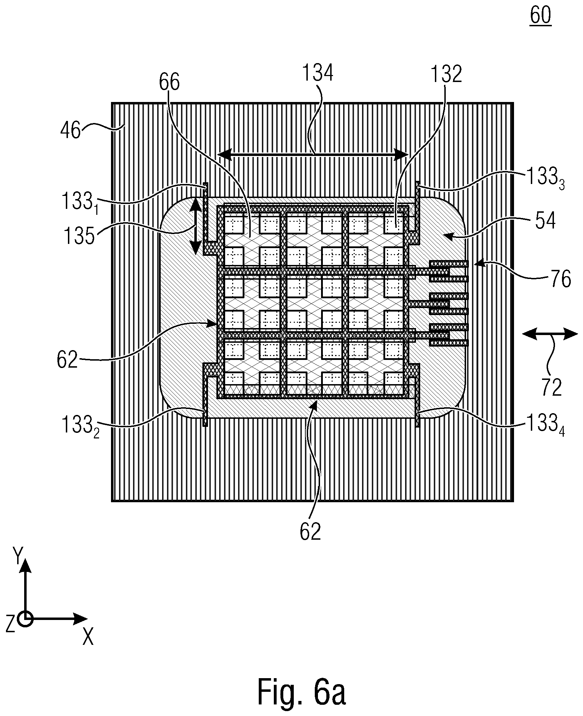

Fig. 6a shows a schematic top view of a part of a MEMS device 60 according to an embodiment, wherein the details provided may be applied, without limitation, to other MEMS devices described herein. The MEMS device 60 may form a part of a MEMS package described herein, e.g., a woofer.

In particular, a layer of the shutter structure 62 is shown. A two-dimensional layout of the structural section 66 of the shutter structure 62 is shown, leading also to a two-dimensional arrangement of openings 132 that may overlap openings 64 of a perforated structure in the first state. One or more spring structures 133₁ to 133₄ may form a part of the MEMS device 60. The at least one spring structure 133₁ to 133₄ may be formed, for example, as a ridge or other type of spring that may allow to move the shutter structure 62 along the x- and/or y-direction whilst preventing such a movement, for example, along a z-direction. A geometry of spring structures 133₁ to 133₄ may also restrict a movement of the shutter structure 62 along one of the directions x and y whilst facilitating the movement along the other direction, e.g., the direction x along which the actuator structure 76 may generate a force so as to deflect the shutter structure 62. That is, the spring structure may, at least in the combination of spring elements, comprise an out-of-plane mechanical stiffness along the z direction being larger when compared to an in-plane mechanical stiffness along the direction of movement 36.

The spring structures 133₁ to 133₄ may elastically hinge the shutter structure 62, e.g., at the substrate 46 and/or at the stator or perforated structure 58 in a rest position, the actuator structure 76 configured for deflecting the shutter structure 62 in-plane along a direction of movement, e.g., x, and out of the rest position.

An extension 134 of the shutter structure 62 along x and/or y may be, for example, in a range of at least 500 µm and some millimeter, e.g., around 1 mm. A length 135 of the spring structures 133₁ to 133₄ may be in a range of at least 50 µm and at most 300 µm, at least 70 µm and at most 200 µm or at least 90 µm and at most 150 µm, e.g., 100 µm. Those dimensions are example values only as well as the number of spring structures 133. For example, one, two, three or more than four spring structures 133 may be arranged, e.g., six, eight, nine or more. Alternatively or in addition, the structural extensions may comprise any other value.

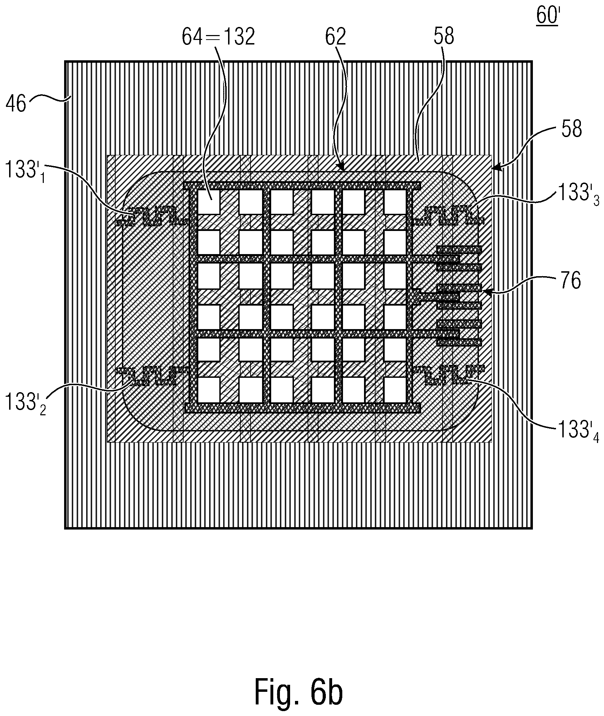

Fig. 6b shows as schematic top view of a layer of the perforated structure 58 according to an embodiment. When compared to the MEMS structure 60, spring elements 133'₁ to 133'₄ may be configured for compression and elongation whilst spring structures 133₁ to 133₄ may be configured for bending.

As may be seen from Fig. 6b, openings 64 and 132 may overlap in the illustrated first position of the shutter structure 62.

Based on spring structures 133, 133' and/or a combination thereof which forms also an embodiment, the shutter structure 62 and the at least one spring structure may form at least a part of a resonator having a resonance frequency, said resonance frequency being in the ultrasonic frequency range of, for example, at least 20 kHz, at least 30 kHz, at least 40 kHz or more.

As is described, for example, in connection with Figs. 6a and 6b, the MEMS device may comprise a spring structure elastically hinging the shutter structure 62 at the substrate 46 in a rest position. An actuator structure 76 may be configured for deflecting the shutter structure in-plane along a direction of movement, e.g., direction 74, and out of the rest position.

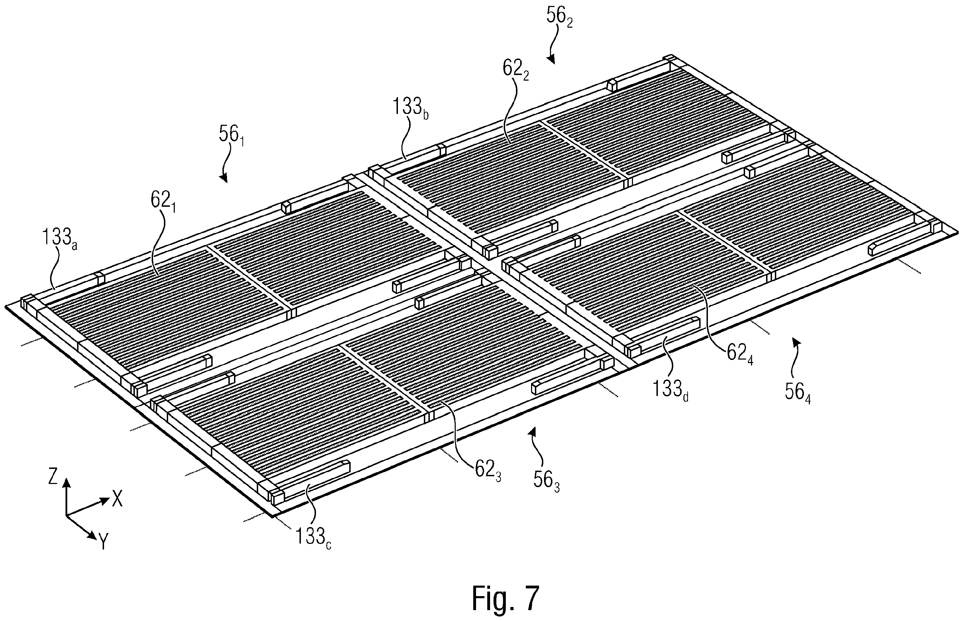

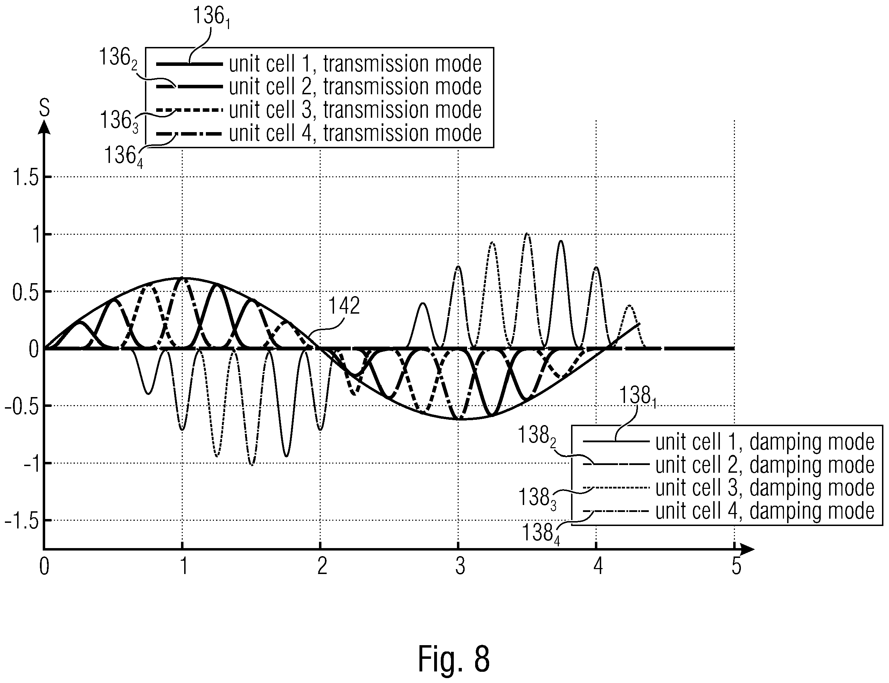

Fig. 7 shows a schematic perspective view of a part of a MEMS device 80 according to an embodiment, wherein the details provided may be applied, without limitation, to other MEMS devices described herein. The MEMS device 80 may form a part of a MEMS package described herein, e.g., a woofer. Therein, for example, more than one, e.g., four valve structures 56₁ to 56₄ may be arranged in a one-dimensional or two-dimensional array. Fig. 8 shows the shutter structures 62₁ to 62₄ of the respective valve structures 56₁ to 56₄. As an example, each shutter structure 62₁ to 62₄ may comprise a dimension of approximately 100 µm × 200 µm in the x/y-plane, wherein other dimensions are possible and/or shutter structures 62₁ to 62₄ may be formed of different sizes.

Fig. 7 illustrates an embodiment where a plurality of valve structures 56₁ to 56₄ sandwich the cavity together with a common membrane structure, wherein a control circuitry being part of or connected to the MEMS structure 80 may be configured for controlling the membrane structure 48 and for individually controlling a position of the plurality of valve structures 56₁ to 56₄ for providing different spectra of the fluidic motion from the cavity with the plurality of valve structures. An individual control may comprise an individual control signal provided by the control circuitry and/or may comprise different resonance frequencies of a respective resonator structure which may comprise different stiffnesses of spring structures 133a to 133d that may hinge the respective shutter structure 62₁ to 62₄ and/or different masses contributing to the resonator structure.

This may result in different frequencies of movement for the resonator structures 62₁ to 62₄ to a respective control signal having the intended frequency or being of a broadband characteristic so as to excite resonant movement of one, more or all of the resonator structures.

This may allow to generate more than a single tone or frequency component with the MEMS structure at a time.

Fig. 8 shows a schematic diagram for illustrating such a concept. There is plotted a time axis at the abscissa and an example normalized sound pressure level S at the ordinate. Plots 136₁ to 136₄ schematically show pressure levels generated with a respective unit cell, e.g., by use of one of shutter structures 62₁ to 62₄ of MEMS device 80. Based on different pressure pulses, an overall sound 142 may be formed based on a superposition of partial sound pressure contributions 136₁ to 136₄. Plots 138 show, for a respective same cell the contribution in a damping mode, i.e., during a time where the membrane moves backward but where the valve structure is closed, wherein, as described above, a synchronization is not required. In other words, the vibration of the membrane structure on the one hand and the vibration related to the operation of the valve structures on the other hand may remain unsynchronized. According to an embodiment, the valve columns itself may have a constant phase shift of, e.g., 90°, to each other.

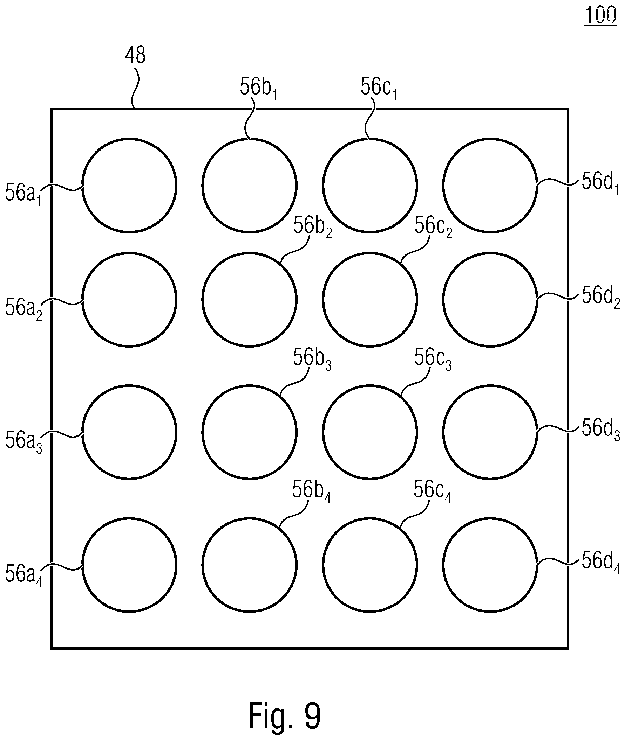

Fig. 9 shows a schematic top view of a part of a MEMS device 100 according to an embodiment, wherein the details provided may be applied, without limitation, to other MEMS devices described herein. The MEMS device 100 may form a part of a MEMS package described herein, e.g., a speaker arrangement that may be used, for example, as a woofer.

In acoustic communication with a single membrane structure 48, an arrangement of valve structures 56a₁ to 56d₄ may be arranged in four lines and four columns. This does not exclude to have a second, further membrane structure in acoustic communication with additional valve structures and/or to have a different number of valve structures, a different number of lines and/or a different number of columns of valve structures in communication with the membrane structure 48. For example, valve structures 56a₁ to 56a₄ may be formed so as to comprise a same resonance frequency, e.g., based on spring structures. Valve elements 56b₁ to 56b₄ may comprise a different second resonance frequency whilst valve structures 56c₁ to 56c₄ and 56d₁ to 56d₄ may comprise a third and fourth resonance frequency. Based on a suitable control signal, this may allow to contribute with different spectra to the audible signal, e.g., for the ultrasonic demodulation being implemented in the MEMS device. A use of one, two, three or four of the respective valve structure 56a, 56b, 56c or 56d may allow to increase or reduce a sound pressure contribution of said frequency, whilst a deactivation of all of the respective valve structures having a resonance frequency may lead to an absence of said spectrum. As described, such a MEMS device may be configured for a use with an ultrasonic demodulation concept, e.g., to individually operate different valve structures in communication with a same membrane with different operation frequencies.

Such a structure may allow for a detailed controlled of the generated output. For example, the membrane may be operated at a resonance frequency thereof and valve structures may be operated at a resonance frequency thereof. A vibration or movement of the shutter structure of different rows may be operated in resonance each and with a phase shift of 90° with regard to one another to emulate the analogue sound. An amplitude of the sound may be adapted via a parallel path having a further shutter structure.

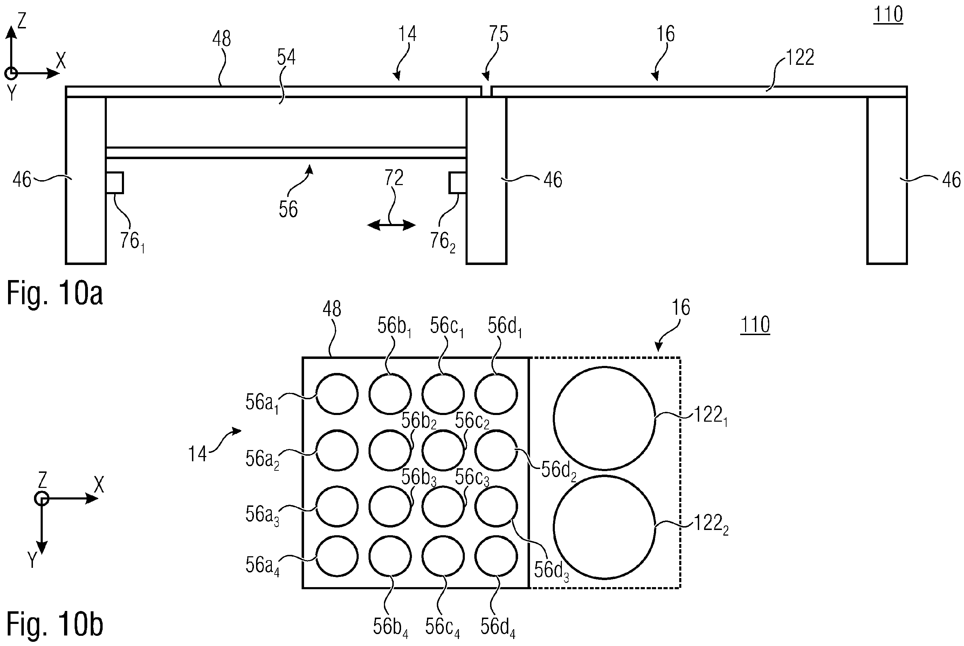

In view of the above, at least the speaker arrangement 14 may be configured as an ultrasonic demodulation speaker. Such a configuration is shown in Fig. 10a showing a schematic side view of a MEMS combo speaker device 110 according to an embodiment.

The MEMS device 110 may comprise speaker arrangements 14 and 16 that may share back volume 75 as a common back volume. For example, a housing of the MEMS device 110 or of other MEMS devices described herein may provide for a common back volume for the first speaker arrangement and the second speaker arrangement.

The MEMS device 110 may comprise the speaker arrangement 14, e.g., to form a part of a MEMS package described herein, e.g., a woofer part. Therein, the membrane structure 48 may deflect so as to generate pressure in cavity 54. A shutter structure of valve structure 56 may be realized, for example, in accordance with MEMS device 30 shown in Fig. 3. When referring to Fig. 10b, the shutter structure 62 of Fig. 3 may implement a structure of one of the valve structures 56a₁ to 56d₄ resulting possibly in a plurality of shutter structures for the plurality of valve structures 56. To use a common back volume 75 may the allow to obtain a packaged MEMS speaker that is compact when compared to other combinations of a speakers such as a tweeter and a woofer.

When referring again to Fig. 1a and Fig. 1b, a housing of the MEMS device, e.g., housing 12, may comprise at least one opening or a set or arrangement of openings at least partially transparent and/or adapted for the audio signal 22 to allow a travel thereof outside the housing. Alternatively or in addition, the housing may comprise at least one opening or a set or arrangement of openings at least partially transparent and/or adapted for the audio signal 24 to allow a travel thereof outside the housing. Such openings may be arranged adjacently to the respective speaker arrangement, e.g., along a direction along which audio signals 22 and/or 24 are emitted. According to an embodiment, the speaker arrangements 14 and 16 and or further arrangements may share such a sound opening or a plurality thereof in the housing.

The MEMS device 110 may comprise a single or more than a single actuator, e.g., actuator structures 76₁ and 76₂ and/or possible further actuator structures so as to generate active forces along positive and negative directions of movement 72. This may allow for a highly controllable generation of sound when compared to relying on restoring forces of springs only.

An example of a possible implementation of the valve structures is shown in the schematic top view of Fig. 10b. Fig. 10b shows a schematic top view of the MEMS combo speaker 110, wherein the speaker arrangement 14 is implemented according to the configuration described in connection with Fig. 9 and wherein speaker arrangement 16 may comprise membrane structures 122₁ and 122₂ to generate the acoustic waves 24. As shown in Fig. 10b, more than a single membrane structure 122 may be part of the speaker arrangement 16. Although, according to some implementations, a single membrane structure 122 may generate sufficient sound pressure, a use of two or more membrane structures 122, e.g., 3, 4, 5 or more may allow for additional amplitude in the signal and/or for additional frequency ranges.

The speaker arrangements 14 and 16 may be formed on a same die, e.g., silicon substrate that may, without any limitation, also be formed on separate dies that are combined with each other within the respective package.

As shown in Fig. 10b, the speaker arrangement 14 may comprise a membrane structure opposing a plurality of valve structures 56, wherein each configuration of valve structures 56a, 56b, 56c and 56d may comprise an individual mechanical resonance and may be configured for operating at the mechanical resonance. The plurality of valve structures may be configured for commonly providing the audio signal 22 in the respective audio frequency range. To use an increased number of valve structures of a same type may allow to provide for additional sound pressure level within this frequency range. A respective control circuitry may operate so as to not only select which type 56a, 56b, 56c or 56d to be used, e.g., by providing a respective control signal, e.g., using appropriate filters, but may also determine a number of valve structures 56 to be used from a respective type. A use of an individual mechanical resonance may be a part of one solution of generating a movement of the shutter structures with different frequencies. Alternatively or in addition to individua mechanical resonance frequencies that may be used for a respective resonant operation, for operating different valve structures at different frequencies, a non-resonant operation may be implemented in MEMS devices described herein. For example, a non-resonant operation mode may comprise a control to obtain snapping, an electro-mechanical pull-in or the like.

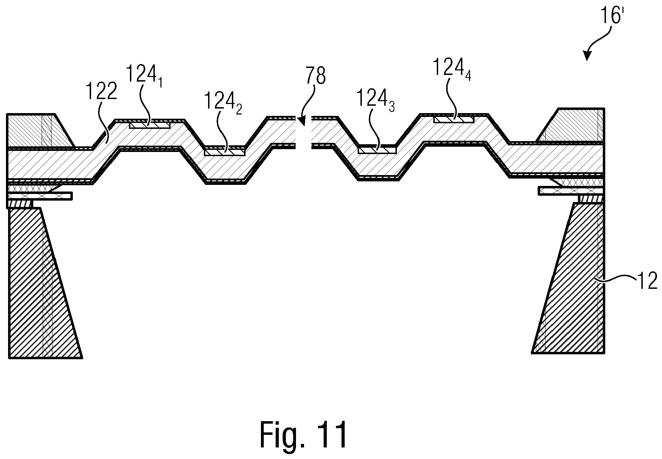

As shown, for example, in Figs. 7 and 11a, according to an embodiment, the speaker arrangement 14 may comprise substrate 46 comprising cavity 54 and comprises a membrane structure 48 mechanically connected to the substrate 46 and configured for deflecting out-of-plane with regard to a substrate plane and with a frequency in an ultrasonic frequency range.

As shown, for example, in Figs. 7 and 11a, according to an embodiment, the speaker arrangement 14 may comprise subs rate 46 comprising cavity 54 and comprises a membrane structure 48 mechanically connected to the substrate 46 and configured for deflecting out-of-plane with regard to a substrate plane and with a frequency in an ultrasonic frequency range.

One or more valve structures 56 may be arranged so as to sandwich the cavity together with the membrane structure 48, wherein the valve structure may comprise a planar perforated structure 58 and a shutter structure 62 arranged moveable in-plane and with a frequency in the ultrasonic frequency range and with regard to the substrate plane and between a first position and second position. That is, the shutter structure 62 may be moved in parallel to a layer parallel to the longitudinal directions x/y. The shutter structure 26 may be arranged to provide a first fluidic resistance, e.g., to enable the fluid flow, for the fluid in the first position and a second, higher fluidic resistance, e.g., to at least partly block the fluid flow, for the fluid in the second position.

Fig. 11 shows a schematic side view of an implementation 16' of the speaker arrangement 16 having piezoelectric elements 124₁ to 124₄ to deflect membrane structure 122. Elements 124₁ to 124₄ may be group wise connected to each other or form a same segment. That is, the speaker arrangement 16 may comprise at least piezo electrically driven membrane structure configured for generating the sound in the respective audio frequency range.

According to an embodiment, the speaker arrangement 12 comprises a thermoelectrically speaker, e.g., a membrane structure that is deflectable based on a thermoelectric concept or thermoelectric principle. Such an actuator may operate in accordance with a principle to actuate a photoacoustic sensor. According to embodiments, a micro audio speaker module may comprise a combination of MEMS tweeter and a MEMS woofer in one assembly including an ASIC that provides the appropriate voltage levels and signal preconditioning for the tweeter and woofer. However, the ASIC may also be an external component. According to an embodiment, as module described herein may be implemented that the woofer is based on an ultrasonic demodulation principle like ADSR, a single or a dual side band modulation and/or the tweeter may be based on an analog audio frequency mechanically actuated membrane or cantilever structure.

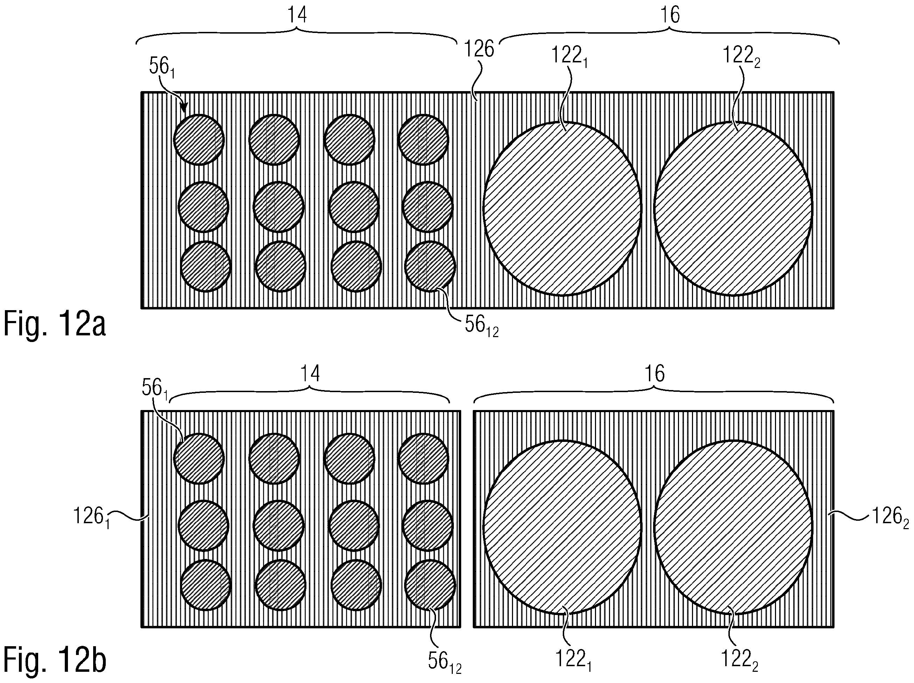

Fig. 12a shows a schematic top view of a MEMS die 126 according to an embodiment, wherein the ultrasonic demodulation, UD, part comprising, by way of non-limiting example, valve structures 56₁ to 66₁₂ to oppose a single membrane structure, are formed on a same die when compared to membrane structures 122₁ and 122₂ forming speaker setup 16.

In Fig. 12b, the speaker setups 14 and 16 are arranged on different dies 126₁ and 126₂. A combination of the embodiments of Fig. 12a and Fig. 12b is possible without limitation, i.e., to have separate dies for any groups of membrane structures.

According to an embodiment, the different speaker arrangements 14 and 16 being part of a MEMS device described herein, may not only operate in different audio frequency ranges but may also operate based on different principles. For example, whilst a speaker arrangement may operate based on a thermoelectric actuation, e.g., in combination with electrodynamic actuators to drive the valves, a different speaker arrangement may operate based on a piezoelectric actuator. That is, not only the structure but also the actuator principle may differ between the speaker arrangements. As an alternative or in addition, the principle of generating the audio frequency range may also differ. Whilst speaker arrangement 16 described herein may generate the audible frequency range itself by use of the membrane, the lower frequencies, e.g., of speaker setup 14, may benefit from an additional valve structure to allow some sort of pump mechanism in the front volume to aggregate pressure level.

According to embodiments, the ASIC and the MEMS may be assembled in one housing. Alternatively, the MEMs may be assembled in one housing and the ASIC may even be part of an external system, e.g., a system-on-a-chip SoC. As an alternative, the MEMS woofer and MEMS tweeter may be integrated on the same substrate or die. As an alternative hereto, the MEMS woofer and MEMS tweeter may even be integrated on separate substrates or dies.

Embodiments relate on the finding that the a combination of two micro speaker concepts that have their respective sweet-spot in different frequency ranges may be used to cover a larger, e.g., anti-audio band with a high sound pressure level and a high efficiency. A particular combination of an ultrasonic, pump based woofer, e.g., using an ultrasound demodulation like ADSR, a single-sideband demodulation or dual-sideband demodulation techniques with an analog tweeter as well as a thermos-acoustic woofer in combination with an analog tweeter. These considerations support both, a single die integration or a dual die solution.

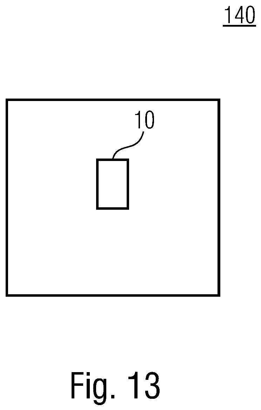

Fig. 13 shows a schematic block diagram of an audio device 140 according to an embodiment that comprises a MEMS package as described herein. For example, MEMS package 10 may form at least a part of the audio device 140, wherein any other MEMS package described herein may be included as an alternative or in addition. The audio device 140 is configured for providing acoustic sounds based on the first audio frequency range and based on the second audio frequency range.

Some embodiments in accordance with the present disclosure relate are described in the following:
According to a first aspect, a MEMS device comprises:
a first speaker arrangement being configured for emitting sound in a first audio frequency range;
at least a second speaker arrangement being configured for emitting sound in a different second audio frequency range.

According to a second aspect making reference to aspect 1, the first speaker arrangement is configured as woofer; and wherein the second speaker arrangement is configured as a tweeter.

According to a third aspect making reference to aspect 1 or 2, the MEMS device comprises a housing that provides for a common back volume for the first speaker arrangement and the second speaker arrangement, in particular wherein the housing is arranged to further provide for electrically connecting the first speaker arrangement and the second speaker arrangement to an environment of the package.

According to a fourth aspect making reference to one of previous aspect, the first speaker arrangement and the second speaker arrangement are formed on a same die.

According to a fifth aspect making reference to one of aspects 1 to 4, the MEMS device comprises a control circuitry configured for receiving an input signal comprising audio information; and
wherein the control circuitry is configured for deriving a first control signal from the input signal, the first input signal adapted for the first speaker arrangement; and for providing the first control signal to the first speaker arrangement; and
wherein the control circuitry is configured for deriving a second control signal from the input signal, the second input signal adapted for the second speaker arrangement; and for providing the second control signal to the second speaker arrangement.

According to a sixth aspect making reference to aspect 5, the control circuitry comprises a lowpass filter for the deriving the first control signal and comprises a highpass filter for the deriving the second control signal.

According to a seventh aspect making reference to one of aspects 1 to 4, the MEMS device comprises an electrical connector configured for a connection with an external control circuitry.

According to a eighth aspect making reference to one of aspects 1 to 7, at least the first speaker arrangement is configured as ultrasonic demodulation speaker.

According to a ninth aspect making reference to aspect 8, the first speaker arrangement comprises a membrane structure one a first side of a plurality of substrate cavities being adjacently arranged; wherein the first speaker arrangement comprises a corresponding plurality of valve structures on a second side of the plurality of cavities; wherein the MEMS device is configured for operating each valve structure at an individual frequency; wherein the plurality of valve structures is configured for commonly providing the first audio frequency range from a fluid motion generated by the membrane structure.

According to a tenth aspect making reference to one of previous aspects, the first speaker arrangement comprises:
a substrate comprising a cavity;
a membrane structure mechanically connected to the substrate and configured for deflecting out-of-plane with regard to a substrate plane and with a frequency in an ultrasonic frequency range to cause a fluid motion in the cavity;
a valve structure sandwiching the cavity together with the membrane structure;
wherein the valve structure comprises a planar perforated structure;
wherein the valve structure comprises a shutter structure opposing the perforated structure and arranged moveably in-plane and with a frequency in the ultrasonic frequency range and with regard to the substrate plane and between a first position and a second position;
wherein the shutter structure is arranged to provide a first fluidic resistance for the fluid motion in the first position and a second, higher fluidic resistance for the fluid motion in the second position.

According to an eleventh aspect making reference to aspect 10, the MEMS device comprises a spring structure elastically hinging the shutter structure at the substrate structure in a rest position; and comprising an actuator structure configured for deflecting the shutter structure in-plane along a direction of movement and out of the rest position.

According to a twelfth aspect making reference to aspect 10 or 11, the MEMS device comprises a bump structure between the perforated structure and the shutter structure, the bump structure configured for adjusting a minimum distance between the perforated structure and the shutter structure.

According to a thirteenth aspect making reference to one of aspects 1 to 7, the first speaker arrangement comprises a thermoelectrically speaker.

According to a fourteenth aspect making reference to one of previous aspects, the second speaker arrangement comprises at least one piezoelectrically driven membrane structure configured for generating the sound in the first audio frequency range.

According to a fifteenth aspect an audio device comprises a MEMS device according to one of previous aspects and configured for providing acoustic sound based on the first audio frequency range and based on the second audio frequency range.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The above described embodiments are merely illustrative for the principles of the present disclosure. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

## Claims

1. A MEMS device comprising:
a first speaker arrangement being configured for emitting sound in a first audio frequency range;
at least a second speaker arrangement being configured for emitting sound in a different second audio frequency range.

2. The MEMS device of claim 1, wherein the first speaker arrangement is configured as woofer; and wherein the second speaker arrangement is configured as a tweeter.

3. The MEMS device of claim 1 or 2, wherein the MEMS device comprises a housing that provides for a common back volume for the first speaker arrangement and the second speaker arrangement, in particular wherein the housing is arranged to further provide for electrically connecting the first speaker arrangement and the second speaker arrangement to an environment of the package.

4. The MEMS device of one of previous claims, wherein the first speaker arrangement and the second speaker arrangement are formed on a same die.

5. The MEMS device of one of claims 1 to 4, comprising a control circuitry configured for receiving an input signal comprising audio information; and
wherein the control circuitry is configured for deriving a first control signal from the input signal, the first input signal adapted for the first speaker arrangement; and for providing the first control signal to the first speaker arrangement; and
wherein the control circuitry is configured for deriving a second control signal from the input signal, the second input signal adapted for the second speaker arrangement; and for providing the second control signal to the second speaker arrangement.

6. The MEMS device of claim 5, wherein the control circuitry comprises a lowpass filter for the deriving the first control signal and comprises a highpass filter for the deriving the second control signal.

7. The MEMS device of one of claims 1 to 4, wherein the MEMS device comprises an electrical connector configured for a connection with an external control circuitry.

8. The MEMS device of one of claims 1 to 7, wherein at least the first speaker arrangement is configured as ultrasonic demodulation speaker.

9. The MEMS device of claim 8, wherein the first speaker arrangement comprises a membrane structure one a first side of a plurality of substrate cavities being adjacently arranged; wherein the first speaker arrangement comprises a corresponding plurality of valve structures on a second side of the plurality of cavities; wherein the MEMS device is configured for operating each valve structure at an individual frequency; wherein the plurality of valve structures is configured for commonly providing the first audio frequency range from a fluid motion generated by the membrane structure.

10. The MEMS device of one of previous claims, wherein the first speaker arrangement comprises:
a substrate comprising a cavity;
a membrane structure mechanically connected to the substrate and configured for deflecting out-of-plane with regard to a substrate plane and with a frequency in an ultrasonic frequency range to cause a fluid motion in the cavity;
a valve structure sandwiching the cavity together with the membrane structure;
wherein the valve structure comprises a planar perforated structure;
wherein the valve structure comprises a shutter structure opposing the perforated structure and arranged moveably in-plane and with a frequency in the ultrasonic frequency range and with regard to the substrate plane and between a first position and a second position;
wherein the shutter structure is arranged to provide a first fluidic resistance for the fluid motion in the first position and a second, higher fluidic resistance for the fluid motion in the second position.

11. The MEMS device according to claim 10, comprising a spring structure elastically hinging the shutter structure at the substrate structure in a rest position; and comprising an actuator structure configured for deflecting the shutter structure in-plane along a direction of movement and out of the rest position.

12. The MEMS device of claim 10 or 11, comprising a bump structure between the perforated structure and the shutter structure, the bump structure configured for adjusting a minimum distance between the perforated structure and the shutter structure.

13. The MEMS device of one of claims 1 to 7, wherein the first speaker arrangement comprises a thermoelectrically speaker.

14. The MEMS device of one of previous claims, wherein the second speaker arrangement comprises at least one piezoelectrically driven membrane structure configured for generating the sound in the first audio frequency range.

15. Audio device comprising a MEMS device according to one of previous claims and configured for providing acoustic sound based on the first audio frequency range and based on the second audio frequency range.
